(19) Europäisches Patentamt

European Patent Office

Office européen des brevets

(11) Veröffentlichungsnummer: **0 180 065 B1**

(12) **EUROPÄISCHE PATENTSCHRIFT**

(45) Veröffentlichungstag der Patentschrift:
08.02.89

(21) Anmeldenummer: **85112684.7**

(22) Anmeldetag: **07.10.85**

(51) Int. Cl.⁴: **H 04 B 3/14**

(54) Einstellbarer Laufzeitenentzerrer mit parabelartigem Verlauf der Gruppenlaufzeit.

(30) Priorität: **08.10.84 DE 3436860**

(43) Veröffentlichungstag der Anmeldung:
**07.05.86 Patentblatt 86/19**

(45) Bekanntmachung des Hinweises auf die Patenterteilung:
**08.02.89 Patentblatt 89/6**

(84) Benannte Vertragsstaaten:
**AT CH DE FR IT LI NL SE**

(56) Entgegenhaltungen:
**DE-A- 2 833 607**
**FR-A- 2 407 609**

**FREQUENZ, Band 38, Nr. 3, März 1984, Seiten 54-62, Berlin, DE; G. PFITZENMAIER: "Ein Beitrag zur Realisierung einstellbarer Laufzeitentzerrer mit Fixpunkten"**

(73) Patentinhaber: **Siemens Aktiengesellschaft Berlin und München, Wittelsbacherplatz 2, D-8000 München 2 (DE)**

(72) Erfinder: **Pfitzenmaier, Gerhard, Dr.-Ing., Hörkherstrasse 28, D-8000 München 21 (DE)**

## Beschreibung

Die Erfindung betrifft einen einstellbaren Laufzeitentzerrer gemäss dem Oberbegriff des Patentanspruches 1.

In Nachrichtenübertragungssystemen, wie z.B. Satellitensystemen, werden einstellbare Laufzeitentzerrer benötigt, deren Gruppenlaufzeit in Abhängigkeit von der Frequenz nach Art einer achssymmetrischen Parabel der auch nicht ganzzahligen Ordnung m verläuft und bei denen eine Veränderbarkeit der Parabelöffnung bei gleichzeitiger Erhaltung der Parabelordnung m und wenigstens näherungsweiser Fixierung des Parabelscheitels erreicht werden muss; die Betriebsdämpfung der Laufzeitentzerrer soll in Abhängigkeit von der Frequenz möglichst konstant sein.

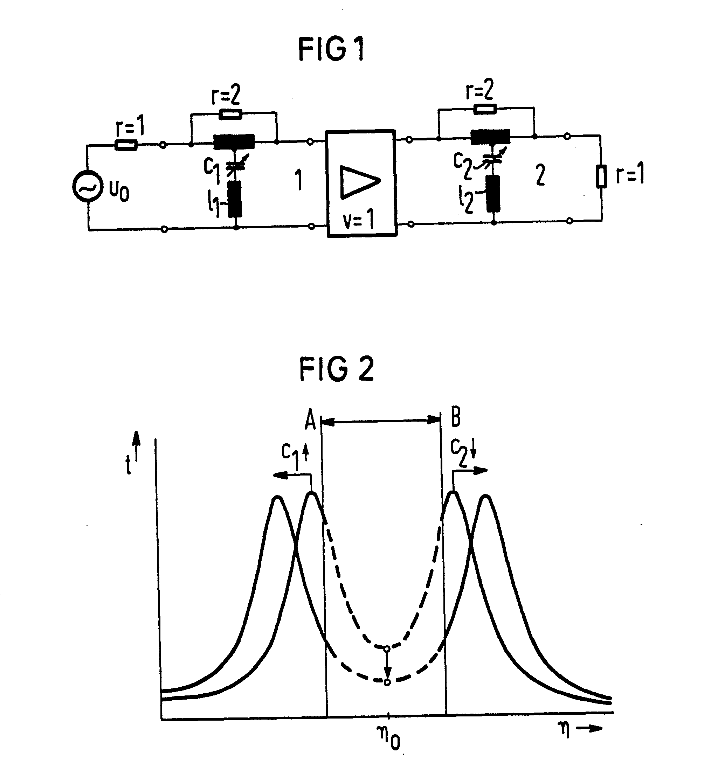

Es ist z.B. durch den Aufsatz V.A. Polukhin, V.S. Putrin «Adjustable Phase Equalizer», Telecommunications, Vol. 24, No. 7, 1970 bekannt, dass einstellbare Laufzeit-Parabel-Entzerrer durch die Kettenschaltung zweier Allpass-B- Glieder — in der Praxis vorzugsweise durch die entkoppelte Kettenschaltung zweier sogenannter Darlington-Entzerrer (vgl. Fig. 1) realisiert — dadurch verwirklicht werden können, dass in der erwähnten Darlington-Realisierung der Serienschwingkreis $l_1$, $c_1$ so bemessen ist, dass das Laufzeitmaximum dieses ersten Laufzeitgliedes frequenzmässig unterhalb der Parabel-Symmetrieachse zu liegen kommt und in entsprechender Weise der Serienschwingkreis $l_2$, $c_2$ so bemessen ist, dass das Laufzeitmaximum dieses zweiten Laufzeitgliedes frequenzmässig oberhalb der Parabel-Symmetrieachse zu liegen kommt. Für die Werte der Schaltelementwerte ist auch in den folgenden Figuren eine an sich bekannte Frequenznormierung bzw. eine Widerstandsnormierung vorgenommen. Die Einstellbarkeit der Parabelöffnung wird bekanntermassen so vorgenommen, dass der Elementewert des einstellbaren Kondensators $c_1$ vergrössert wird und synchron dazu der Elementewert des einstellbaren Kondensators $c_2$ verkleinert wird, wodurch eine Verschiebung des frequenzmässig unteren Laufzeitmaximums nach tieferen Frequenzen hin und gleichzeitig eine Verschiebung des frequenzmässig oberen Laufzeitmaximums nach höheren Frequenzen hin bewirkt wird. Die Folge ist eine Laufzeitparabel mit einer flacheren Öffnung als vorher, wie dies z.B. in Fig. 2 dargestellt ist. Nachteilig bei diesem Verfahren wirkt sich aus, dass sich das absolute Niveau des frequenzstabilen Parabelscheitels in Abhängigkeit von der eingestellten Parabelöffnung ändert, wie dies ebenfalls z.B. aus Fig. 2 hervorgeht.

Zur wenigstens näherungsweisen Fixierung des Parabelscheitels werden deshalb in der bekannten Praxis mindestens 2 bzw. 2n (n = 2,3...) weitere Darlington-B-Glieder mit Serienschwingkreisen vorgesehen, deren Wirkungsverhalten ebenfalls symmetrisch zur Parabelachse verläuft und deren Zweck ausschliesslich in einer parabelöffnungsabhängigen Niveauregulierung des Parabelscheitels besteht. Der am Gesamtaufwand des Entzerrers orientierte Schaltungsanteil für die näherungsweise Konstanthaltung des Parabelscheitels ist deshalb unangemessen gross.

Der Erfindung liegt die Aufgabe zugrunde, Entzerrerschaltungen anzugeben, bei denen die Fixierung des Parabelscheitels mit erheblich geringerem Aufwand möglich ist und es wird bereits durch Zuschalten von nur einem Darlington-B-Glied erreicht, dass der Laufzeit-Parabelscheitel näherungsweise konstant gehalten wird.

Gemäss der Erfindung erfolgt die Lösung dieser Aufgabe nach den kennzeichnenden Merkmalen des Patentanspruches 1.

Eine vorteilhafte Ausgestaltung ist im Anspruch 2 angegeben.

Anhand von Ausführungsbeispielen wird nachstehend die Erfindung noch näher erläutert.

Es zeigen in der Zeichnung,

Fig. 1 eine aus zwei entkoppelten Darlington-B-Gliedern bestehende, bekannte Schaltung eines einstellbaren Laufzeitparabelentzerrers,

Fig. 2 das Laufzeitverhalten eines durch die Schaltung nach Fig. 1 realisierten einstellbaren Laufzeitparabelentzerrers; aufgetragen ist die Laufzeit t in Abhängigkeit von einer normierten Frequenz $\eta$,

Fig. 3a für 2 verschiedene Parabelöffnungen ein typisches Laufzeitverhalten eines Allpass-B-Gliedes,

Fig. 3b eine Kreuzgliedschaltung eines Allpass-B-Gliedes,

Fig. 3c die Pol-Nullstellenverteilung der Dämpfungsfunktion eines Allpass-B-Gliedes,

Fig. 4 a, b, c das Laufzeitverhalten eines Allpass-B-Gliedes bei Änderung der Parameter als Beispiel,

Fig. 4a die Referenzkurve für ein entnormiertes Beispiel, bei dem die Induktivität L = 100 nH, die Kapazität C = 12 pF und der Betriebswiderstand $R_B$ = 50 Ohm ist,

Fig. 4b die Veränderung der Laufzeit bei Änderung der Serienschwingkreiskapazität um ± 10%,

Fig. 4c bei Änderung der Serienschwingkreisinduktivität um ± 10% und konstantem C die Änderung der Laufzeit,

Fig. 5a ein erfindungsgemässes Schaltungsbeispiel mit einem zusätzlichen Allpass-B-Glied, bei dem die Niveauregulierung des Laufzeit-Parabel-Scheitels durch Einstellen einer veränderbaren Serienschwingkreisinduktivität erfolgt,

Fig. 5b ein weiteres erfindungsgemässes Beispiel bei dem die Niveauregulierung des Laufzeit-Parabel-Scheitels durch Einstellung einer Parabelschwingkreiskapazität erfolgt.

In Fig. 1 ist dem Grundkonzept nach nochmals eine Schaltung dargestellt, wie sie aus dem einleitend bereits erwähnten Aufsatz «Adjustable Phase Equalizer» bekannt ist. Diese Schaltung besteht aus einem ersten Darlington-B-Glied 1, dem über einen Entkopplungsverstärker mit dem Verstärkungsfaktor 1 (v = 1) ein zweites Darlington-B-Glied 2 nachgeschaltet ist. Der Vollständigkeit halber ist die Spannungsquelle $u_0$ mit ihrem normierten Innenwiderstand r = 1 mitgezeichnet. Wegen der Widerstandsnormierung ist auch der Abschlusswiderstand mit r = 1 bezeichnet. Die Darlington-B-Glieder bestehen in an sich bekannter Weise je aus einem Differentialübertrager, der mit dem ohmschen Widerstand r = 2 überbrückt ist, und einem Serienresonanzkreis aus einer einstellbaren Kapazität $c_1$ und der Induktivität $l_2$ bzw. aus einer einstellbaren Kapazität $c_2$ und der

Induktivität $l_2$ im Querzweig. In Fig. 2 ist nun das Laufzeitverhalten t in Abhängigkeit von einer normierten Frequenz $\eta$ aufgetragen, wobei zu erkennen ist, dass der Parabelscheitel bei der normierten Frequenz $\eta_0$ liegt; der ausgenutzte Frequenzbereich ist durch den mit A und B bezeichneten Pfeil kenntlich gemacht. Durch die nach oben bzw. nach unten zeigenden Pfeile neben den Parametern $c_1$ bzw. $c_2$ soll folgendes zum Ausdruck kommen: Die Steuerung der Parabelöffnung wird durch die Vergrösserung der Kapazität $c_1$ und die synchrone Verkleinerung der Kapazität $c_2$ erreicht. Nachteilig ist bei dieser bekannten Methode jedoch, dass eine parabelöffnungsabhängige Niveauverschiebung des Parabelscheitels bei der Frequenz $\eta_0$ erfolgt, wie dies in Fig. 2 ebenfalls zum Ausdruck kommt.

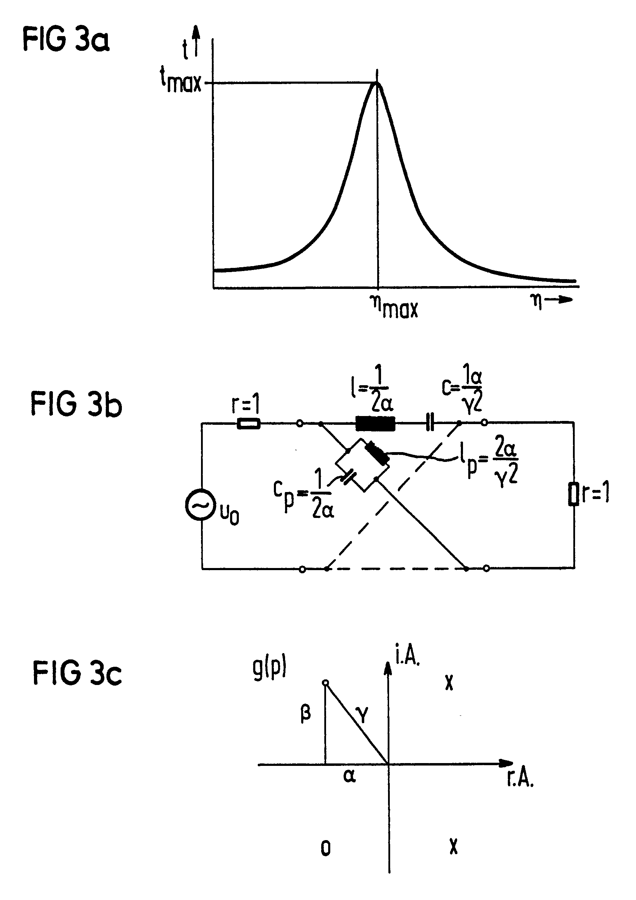

In Fig. 3a ist das typische Laufzeitverhalten eines Allpass-B-Gliedes dargestellt und zwar ist die Laufzeit t in Abhängigkeit von der normierten Frequenz $\eta$ aufgetragen. Erkennbar ist, dass bei einer Frequenz $\eta_{max}$ eine maximale Laufzeit $t_{max}$ auftritt.

In Fig. 3b ist wiederum erkennbar, die Spannungsquelle $u_0$ mit dem Innenwiderstand $r = 1$, ebenso der Abschlusswiderstand $r = 1$. Diese Schaltungsdetails wurden bereits anhand von Fig. 1 erläutert. In der Schaltung von Fig. 3b ist jedoch zum raschen Verständnis die bekannte allgemeine Kreuzgliedschaltung eines Allpass-B-Gliedes gezeichnet. Im oberen Längszweig befindet sich ein Serienresonanzkreis, der aus einer Spule 1 und einem Kondensator c besteht. Im Diagonalzweig befindet sich ein Parallelresonanzkreis, der aus einer Spule $l_p$ und einer Kapazität $c_p$ besteht. Die gestrichelte Linie im zweiten Diagonalzweig macht kenntlich, dass auch dort der gleiche Parallelresonanzkreis geschaltet sein muss, genauso wie die gestrichelte Linie im unteren Längszweig kenntlich macht, dass dort genau der gleiche Serienresonanzkreis wie im oberen Längszweig geschaltet sein muss. Die Bemessung der Schaltelemente erfolgt zweckmässigerweise aus den Nullstellenlagen (in Fig. 3c als kleine Kreise dargestellt) und aus den Pollagen (in Fig. 3c als Kreuzchen dargestellt) der entsprechenden Dämpfungsfunktion, die in der komplexen $g(p)$-Ebene durch Realteil $\alpha$, Imaginärteil $\beta$ und Absolutbetrag $\gamma$ gekennzeichnet sind.

Das typische Laufzeitverhalten eines Allpass-B-Gliedes gemäss Fig. 3b ist in Fig. 3a dargestellt. Charakteristisch ist ein bei der normierten Frequenz $\eta_{max}$ gelegenes Laufzeitmaximum mit der absoluten Höhe $t_{max}$. Beide Werte lassen sich durch den Realteil $\alpha$ und den Imaginärteil $\beta$ bzw. durch den Absolutbetrag $\gamma = \sqrt{\alpha^2 + \beta^2}$ der Nullstellenparameter des Hurwitzpolynoms $g(p)$ ausdrücken wie dies z.B. aus der Literaturstelle «Frequenz» 16, 1962, S. 469-477, (R. Sual, K. Antreich, «Zur Realisierung von Reaktanz-Allpass-Schaltungen») bekannt ist. In bekannter Weise ist die Dämpfungsfunktion $D(p)$ des Allpass-B-Gliedes definiert (Fig. 3c) durch:

$$D(p) = \frac{g(p)}{g(-p)} = \frac{p^2 + 2\alpha p + \gamma^2}{p^2 - 2\alpha p + \gamma^2} \qquad (1)$$

$$\eta_{max} = \gamma \cdot \sqrt{2\beta/\gamma - 1} \, , \qquad (2)$$

$$t_{max} = \frac{\alpha}{\beta(\gamma - \beta)} \, . \qquad (3)$$

Über die nach der vorgenannten Literaturstelle bekannten Dimensionierungsvorschriften für die Kreuzgliedelemente gemäss Fig. 3b

$$1 = \frac{1}{2\alpha} , \quad c = \frac{2}{\gamma^2}$$

können die kennzeichnenden Grössen des Laufzeitmaximums direkt aus den Schaltelementen berechnet werden:

$$\eta_{max} = \sqrt{\frac{1}{lc}\left(\sqrt{4 - \frac{c}{l}} - 1\right)}, \quad 1 > c/3 \qquad (4)$$

$$t_{max} = \frac{2l}{2\sqrt{\frac{l}{c}} \cdot \sqrt{4\frac{l}{c} - 1} - (4\frac{l}{c} - 1)} \qquad (5)$$

$$t(\eta = 2l \cdot \frac{\eta^2 + \frac{1}{lc}}{\eta^2 + l^2(\eta^2 - \frac{1}{lc})^2} \, . \qquad (6)$$

Wie bereits einleitend angedeutet, bewirkt die Variation der Schwingkreiskapazität c eines Allpass-B-Gliedes bzw. Darlington-B-Gliedes eine grössere Verschiebung der Frequenz $\eta_{max}$ des Laufzeitmaximums als eine entsprechende Änderung der Schwingkreisinduktivität 1. Der Beweis für diese Aussage ist zu führen, wenn der Quotient aus den halbrelativen Empfindlichkeiten von $\eta_{max}$ bezüglich c und l

$$\left| \frac{\dfrac{d\eta_{max}}{dc} \cdot c}{\dfrac{d\eta_{max}}{dl} \cdot l} \right| = \left| \frac{c + 2l \cdot \sqrt{4 - c/l} \cdot (\sqrt{4 - c/l} - 1)}{c - 2l \cdot \sqrt{4 - c/l} \cdot (\sqrt{4 - c/l} - 1)} \right| \qquad (7)$$

gebildet und dabei festgestellt wird, dass dieser auf jeden Fall grösser als 1 sein muss, da er sich als Quotient der Summe und der Differenz jeweils gleichartiger Terme darstellt.

Bei der Erfindung wird von der Erkenntnis ausgegangen, dass in entsprechender Weise eine Variation der Schwingkreisinduktivität 1 eine grössere Niveauverschiebung des Laufzeitmaximums $t_{max}$ hervorruft, als eine entsprechende Änderung der Schwingkreiskapazität c. Es lässt sich zeigen, dass für

$$1 > c \frac{1 + \sqrt{5}}{8} \quad (1 > 0{,}4 \, c)$$

der Quotient aus den halbrelativen Empfindlichkeiten von $t_{max}$ bezüglich 1 und c

$$\left| \frac{\dfrac{dt_{max}}{dl} \cdot l}{\dfrac{dt_{max}}{dc} \cdot c} \right| = \left| \frac{-1 + \sqrt{4 - c/l}}{-1 + 8l/c - 4\sqrt{l/c} \cdot \sqrt{4\,l/c - 1}} \right| \tag{8}$$

grösser als 1 ist.

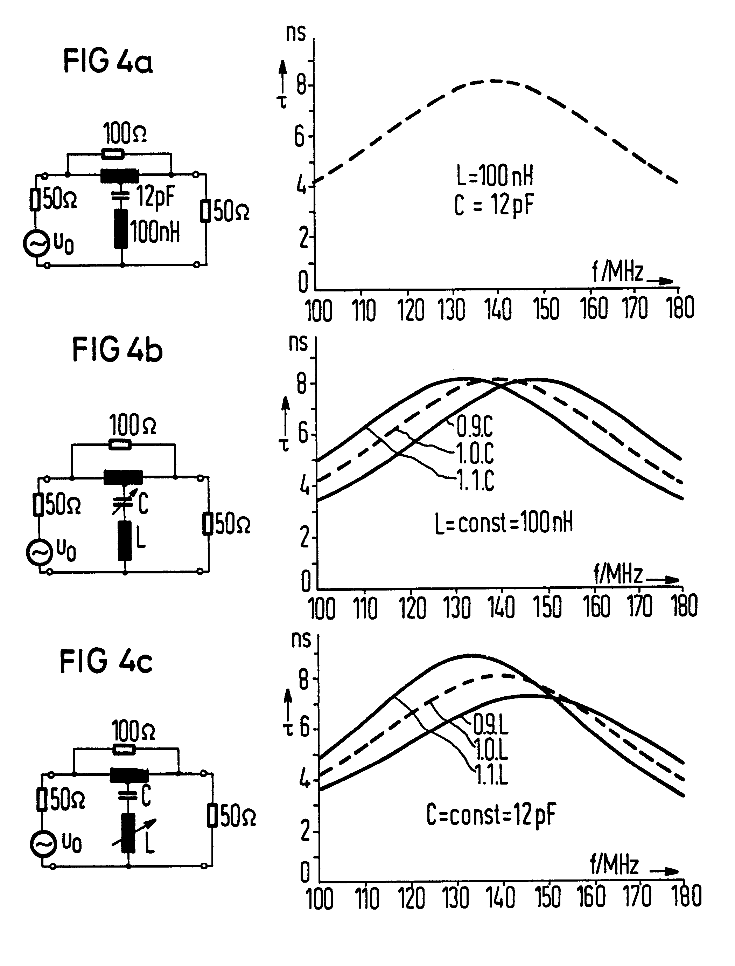

Das erfindungsgemässe Prinzip wird weiterhin am Beispiel eines Allpass-B-Gliedes mit den entnormierten Elementewerten L = 100 nH, C = 12 pF des Serienschwingkreises verdeutlicht. Fig. 4a zeigt die entsprechende Laufzeitkurve im Frequenzbereich f = 100 MHz...180 MHz. Das Laufzeitmaximum $\tau_{max} \approx 8{,}2$ ns liegt bei f $\approx$ 140 MHz. In Fig. 4b ist die entsprechende Kurve jeweils für eine Änderung der Schwingkreiskapazität C um + 10% und um – 10% dargestellt mit L = const. Es ist zu erkennen, dass als Folge eine Frequenzverschiebung des Laufzeitmaximums nach tiefen bzw. hohen Frequenzen hin auftritt, wobei sich der Absolutwert des Laufzeitmaximums $\tau_{max}$ kaum ändert. Dieser Effekt wird zur Steuerung der Laufzeitparabelöffnung verwendet.

Im Gegensatz hierzu ergibt sich bei einer Änderung der Schwingkreisinduktivität L um + 10% bzw. – 10% (C = const) eine kräftige Beeinflussung des Absolutwertes $\tau_{max}$ des Laufzeitmaximums bzw. des Laufzeitwertes bei der betrachteten Mittenfrequenz, wie dies aus Fig. 4c hervorgeht.

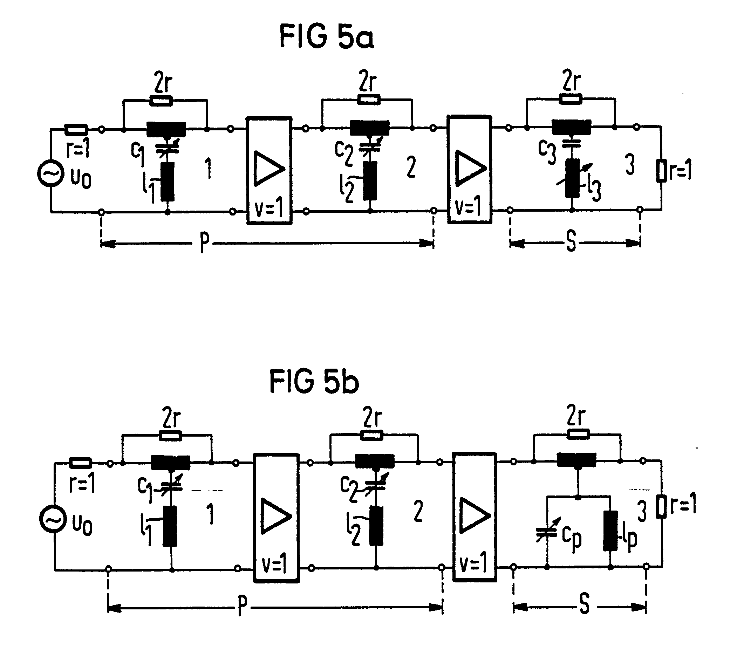

Gemäss der Erfindung ist entsprechend Fig. 5a ein im beschriebenen Sinn bemessenes Allpass-B-Glied 3 (Darlington-B-Glied 3) gut zur Laufzeitniveauregulierung S z.B. in Bandmitte geeignet, wenn es insbesondere entkoppelt den beiden parabelöffnungsbestimmenden (P) Allpass-B-Gliedern 1,2 (Darlington-B-Gliedern 1,2) in Kette nachgeschaltet wird. Die an und für sich mesit geringe, jedoch unerwünschte Frequenzabhängigkeit der Laufzeit des nachgeschalteten Allpass-B-Gliedes 3 (Darlington-B-Gliedes 3) kann wenigstens näherungsweise durch Elementekorrekturen der beiden parabelöffnungsbestimmenden B-Glieder 1,2 (Darlington-B-Glieder 1,2) aufgefangen werden. Um die an Hand der Fig. 4, insbesondere Fig. 4c, geschilderten Vorteile zu erzielen, muss im Darlington-B-Glied 3 von Fig. 5a mit dem Serienresonanzkreis aus dem Kondensator $c_3$ und der Spule $l_3$ die Einstellung der Laufzeit durch Ändern der Spule $l_3$ erfolgen.

Eine für die Laufzeit-Niveauregelung besonders vorteilhafte Schaltung eines Allpass-B-Gliedes 3 (bzw. Darlington-B-Gliedes 3) ergibt sich gemäss Fig. 5b aus der an sich bekannten Möglichkeit, die beiden Brückenreaktanzen eines Allpass-B-Gliedes bei unverändertem Laufzeitverhalten gegenseitig austauschen zu können. Der bisher betrachtete Serienschwingkreis ($l_3$, $c_3$) als Brückenreaktanz geht dadurch in die bezüglich des Abschlusswiderstandes duale Schaltung über, nämlich ein Parallelschwingkreis aus der Spule $l_p$ und den Kondensator $c_p$ und die Rolle der Niveauregulierung für $\tau_{max}$ fällt nunmehr der Kapazität $c_p$ des Parallelschwingkreises zu. In diesem Fall können, wie eine entsprechende, mit drei Darlington-B-Gliedern 1,2,3 ausgestattete Gesamtschaltung in Fig. 5b zeigt, alle Einstellelemente $c_1$, $c_2$, $c_p$ — sowohl zur Steuerung der Laufzeitparabelöffnung ($c_1$, $c_2$), als auch zur Niveauregulierung ($c_p$) des Parabelscheitels S — in technisch günstiger Weise einheitlich durch einstellbare Kondensatoren bzw. durch spannungsgesteuerte Kapazitätsdioden realisiert werden.

## Patentansprüche

1. Einstellbarer Laufzeit-Entzerrer mit parabelartigem Verlauf der Gruppenlaufzeit, bestehend aus zwei voneinander entkoppelten (v = 1) Darlington-B-Gliedern (1; 2) mit kapazitätsgesteuerten ($c_1$; $c_2$) Serienschwingkreisen ($l_1$, $c_1$; $l_2$, $c_2$), dadurch gekennzeichnet, dass dem Parabel-Entzerrer (P) ein zusätzliches Darlington-B-Glied (3) nachgeschaltet ist, dessen laufzeitbestimmende Reaktanz aus einem Serienschwingkreis ($l_3$, $c_3$; Fig. 5a) besteht und die Niveauregulierung des Parabelscheitels S durch die Veränderbarkeit der Serienschwingkreisinduktivität ($l_3$) erfolgt, oder dessen laufzeitbestimmende Reaktanz aus einem Parallelschwingkreis ($l_p$, $c_p$; Fig. 5b) besteht und die Niveauregulierung des Parabelscheitels (S) durch die Veränderbarkeit der Parallelschwingkreiskapazität ($c_p$) erfolgt.

2. Entzerrer nach Anspruch 1, dadurch gekennzeichnet, dass die Entkopplung der einzelnen Glieder (1; 2; 3) über Verstärker mit dem Verstärkungsfaktor 1 (v = 1) erfolgt.

## Claims

1. Adjustable delay time equalizer having a parabolic course of the group delay time, consisting of two mutually decoupled (v = 1) Darlington B elements (1; 2) with capacitance-controlled ($c_1$; $c_2$) series resonant circuits ($l_1$, $c_1$; $l_2$, $c_2$), characterized in that the parabolic equalizer (P) is followed by an additional Darlington B element (3), the delay-time-determining reactance of which consists of a series resonant circuit ($l_3$, $c_3$; Figure 5a) and the level of the crest S of the parabolic is controlled by means of the variability of the series resonant circuit inductance ($l_3$), or the delay-time-determining reactance of which consists of a parallel resonant circuit ($l_p$, $c_p$; Figure 5b) and the level of the crest (S) of the parabolic is controlled by means of the variabiality of the parallel resonant circuit capacitance ($c_p$).

2. Equalizer according to Claim 1, characterized in that the individual elements (1; 2; 3) are decoupled via amplifiers having a gain factor of 1 (v = 1).

**Revendications**

1. Correcteur réglable du temps de propagation, à allure parabolique du temps de propagation de groupe, constirué par deux circuits de Darlington-B (1; 2) découplés l'un de l'autre (v = 1) et possédant des circuits oscillants série ($l_1$, $c_1$; $l_2$, $c_2$) commandés par des capacités ($c_1$; $c_2$), caractérisé par le fait qu'en aval du correcteur à fonction parabolique (P) se trouve branché un circuit de Darlington-B supplémentaire (3), dont la réactance, qui détermine le temps de transit, est formée par un circuit oscillant série ($l_3$, $c_3$; figure 5a) et la régulation du niveau du sommet (S) de la parabole est obtenue au moyen de la possibilité de modification de l'inductance ($l_3$) du circuit oscillant série, ou bien sa réactance, qui détermine le temps de transit, est formée par un circuit oscillant parallèle ($l_p$, $c_p$; figure 5b) et la régulation du niveau du sommet (S) de la parabole est obtenue au moyen de la possibilité de modification de la capacité ($c_p$) du circuit oscillant parallèle.

2. Correcteur suivant la revendication 1, caractérisé par le fait que le découplage des différents circuits (1; 2; 3) est réalisé par l'intermédiaire d'amplificateurs possédant le facteur d'amplificateur 1 (v = 1).

# FIG 1

# FIG 2

FIG 3a

FIG 3b

FIG 3c

## FIG 4a

$L = 100\,nH$
$C = 12\,pF$

## FIG 4b

0.9 C
1.0 C
1.1 C

$L = const = 100\,nH$

## FIG 4c

0.9 L
1.0 L
1.1 L

$C = const = 12\,pF$

# FIG 5a

# FIG 5b